Europäisches Patentamt

(19) European Patent Office

Office européen des brevets

(11) Publication number: **0 047 153**
**B1**

(12) **EUROPEAN PATENT SPECIFICATION**

(45) Date of publication of patent specification: **06.02.85**

(51) Int. Cl.⁴: **H 01 L 29/60,** H 01 L 29/78, G 11 C 17/00

(21) Application number: **81303949.2**

(22) Date of filing: **28.08.81**

(54) Semiconductor memory device.

(30) Priority: **29.08.80 JP 119213/80**

(43) Date of publication of application:
**10.03.82 Bulletin 82/10**

(45) Publication of the grant of the patent:
**06.02.85 Bulletin 85/06**

(84) Designated Contracting States:
**DE FR GB NL**

(56) References cited:
**DE-A-3 002 493**
**US-A-3 825 946**
**US-A-4 099 196**
**US-A-4 203 158**

**IBM TECHNICAL DISCLOSURE BULLETIN, vol. 22, no. 6, November 1979, New York, C.R. HOFFMAN "Floating gate nonvolatile memory cell", pages 2403 to 2404**
**IBM TECHNICAL DISCLOSURE BULLETIN, vol. 21, no. 8, January 1979, New York, T.A. LARSEN et al. "Floating-gate device with dual control gates", page 3368**

(73) Proprietor: **FUJITSU LIMITED**
**1015, Kamikodanaka Nakahara-ku**
**Kawasaki-shi Kanagawa 211 (JP)**

(72) Inventor: **Shirai, Kazunari**
**1310-4, Aza Kurinosawa Bukko-cho**
**Hodogaya-ku Yokohama-shi Kanagawa 240 (JP)**
Inventor: **Tanaka, Izumi**
**2-2-11, Fujizuka Kohoku-ku**
**Yokohama-shi Kanagawa 222 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:
**IBM TECHNICAL DISCLOSURE BULLETIN, vol. 17, no. 8, January 1975, New York, S. DASGUPTA et al. "Dual-gate famos memory cell", page 2266**
**ELECTRONICS, vol. 52, no. 19, 13 September 1979, New York, R.P. CAPECE et al. "Static RAM Tunnels for nonvolatility", pages 39 to 40**
**Funkschau, 1975, Nr. 24, (pp. 56-59), Nr. 25 (pp. 58-62)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Background of the invention
(1) Field of the invention

The present invention relates to an improvement in the semiconductor memory device called "EPROM" (erasable programmable read only memory).

(2) Description of the prior art

In most conventional EPROM devices, information is electrically written and the written information can be erased by irradiation with ultraviolet rays so that repeated use is possible.

Recently, researches have been made on EPROM devices in which both the writing and erasing of information can be performed electrically. As these EPROM devices can be handled very easily, the structure, especially the structure of the package, can be simplified. For example, U.S. Patent No. 3,825,946 discloses an EPROM device which can be charged or discharged electrically. In this device, a second gate and a third gate are adapted so as to cooperatively enable a discharge to take place from a floating gate due to an avalanche injection through an insulating layer having a thickness of about 50 to 100 nm. Namely, to discharge the floating gate, a positive pulse of a high voltage (e.g., approximately 35 volts) is applied to the second gate, with the third gate and the substrate grounded. Also, to charge the floating gate, a positive pulse of a similarly high voltage is applied to the second and third gates, with the substrate grounded. However, application of a high voltage at the time the floating gate is charged and discharged is liable to cause a breakdown. If the floating gate is charged by applying a low voltage, no breakdown is caused even when a high voltage is applied to discharge the floating gate. However, in this case, two electrodes of high and low voltages, respectively, must be provided. If both a charge and a discharge of the floating gate is conducted at a relatively low voltage, reliability for the writing and erasing would be reduced.

US—A—4 203 158 discloses an electrically programmable and electrically erasable MOS memory device using the tunnelling effect for charging and discharging a floating gate electrode. The floating gate is formed above a substrate and is for the most part separated from the substrate by an oxide layer of relatively large thickness. However, in a region of small extent, the floating gate is separated from the substrate by a thin oxide layer of tunnellable thickness. Charging and discharging of the floating gate are effected by charge transfer, by tunnelling through the small extent of thin oxide, between the floating gate and a substrate region which is specially provided for this purpose or forms part of or an extension of a source or drain region in the substrate.

US—A—4 099 196 discloses an electrically erasable memory device using the tunnelling effect for charging and discharging a floating gate electrode. The device employs relatively thick oxide layers throughout, with polysilicon gate electrodes having rough textured upper surfaces, to afford enhanced electric fields to accomplish tunnelling through the thick oxide layers. An erase gate electrode is provided above and overlapping the floating gate electrode (having a rough textured upper surface) and tunnelling takes place between the erase gate electrode and the floating gate electrode for discharging (erasing) the floating gate electrode. A separate program/select electrode, below the floating gate electrode and having a rough textured upper surface, is necessary for charging the floating gate electrode. A separate control gate electrode is also provided.

According to the present invention there is provided a semiconductor memory device which comprises a pair of first gate electrodes, each in an electrically floating state and at least part of each of which confronts a channel region of a semiconductor substrate and is separated by an insulating layer from the channel region confronted; a pair of second gate electrodes, that are control electrodes for controlling the injection of charges into the said first gate electrodes, at least a part of each of which confronts a respective first gate electrode and is separated by an insulating layer from the respective first gate electrode; and a third gate electrode, insulated from the said second gate electrodes, that is an erasing electrode, at least a part of which confronts the two first gate electrodes and is separated from the first gate electrodes by an insulating layer having a tunnellable thickness, allowing passage of charges from the first gate electrodes to the erasing electrode through the tunnelling effect for discharging the first gate electrodes.

An embodiment of the present invention can provide an EPROM device in which electric writing and erasing can be performed with a high reliability and which can easily be fabricated by application of the conventional technique.

Reference is made, by way of example, to the accompanying drawings, wherein:

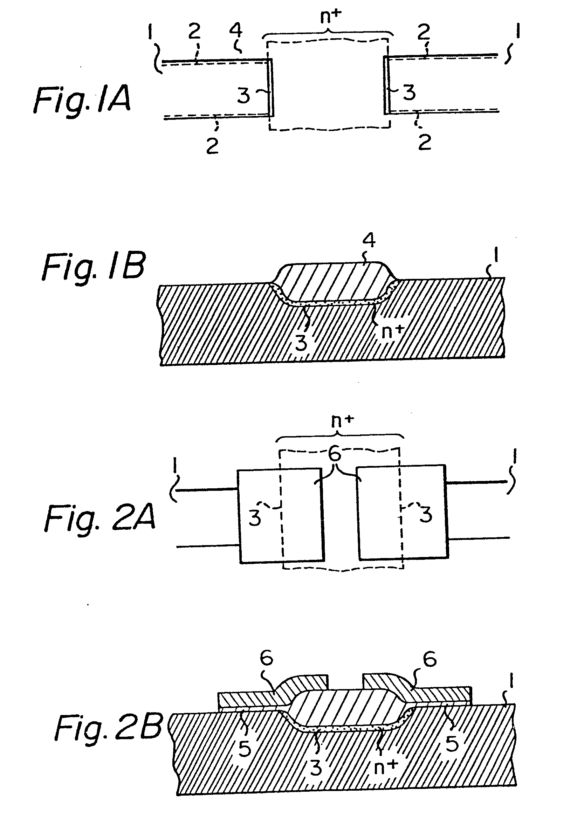

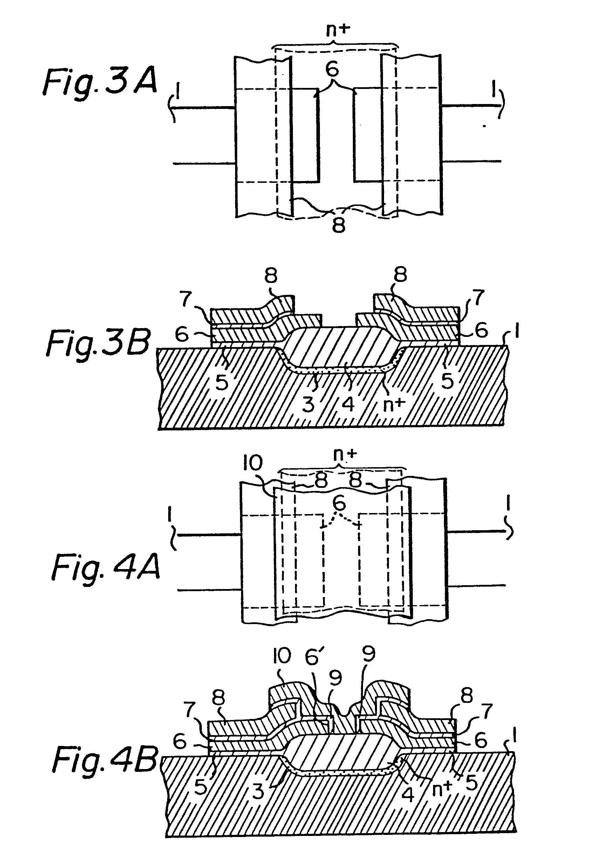

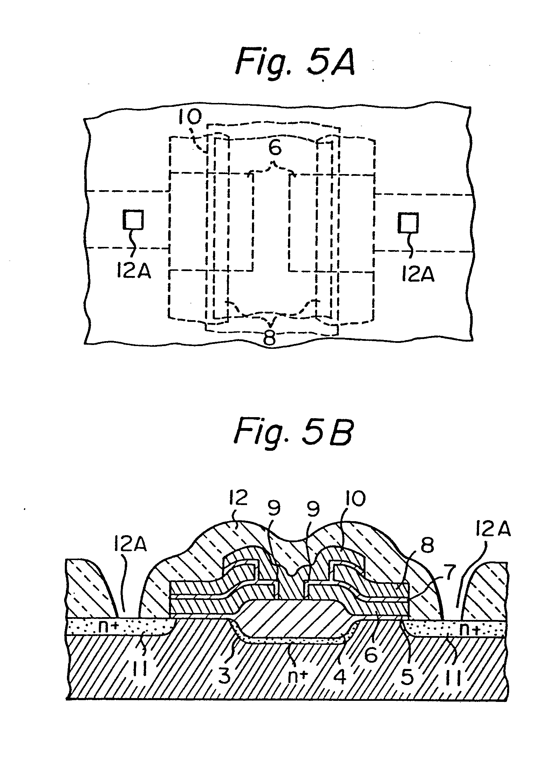

Figs 1A through 6A and 1B through 6B are diagrams illustrating the manufacturing steps of one embodiment of the semiconductor memory device of the present invention, in which Figs. 1A through 6A are top plan views showing the main part of the device and Figs. 1B through 6B are cross-sectional views thereof.

The steps of manufacturing the semiconductor memory device of the present invention will be described with reference to the drawings.

Fig. 1

(1) Boron ions (B$^+$) are injected in a silicon (Si) semiconductor substrate 1 in a dose of, for example, about $1 \times 10^{13}$ ions per $cm^2$ according to the ion implantation method to form a $p^+$ type channel cut region 2.

(2) Arsenic ions ($As^+$) are injected in a dose of, for example, about $5 \times 10^{15}$ per $cm^2$ according to the ion implantation method to form an $n^+$ type region 3 for a line of a power source Vss of the ground potential level.

(3) A silicon dioxide ($SiO_2$) field insulating layer 4 having a thickness of, for example, about 500 to about 1000 nm is formed, for example, according to the selective thermal oxidation method using a silicon nitride ($Si_3N_4$) film mask. When the mask is removed, the surface of the active region of the substrate 1 is exposed.

Fig. 2

(4) A first insulating layer 5 of silicon dioxide having a thickness of about 70 to about 100 nm is formed on the exposed surface of the active region of the substrate 1, for example, according to the thermal oxidation method.

(5) A polycrystalline silicon layer 6, forming the first gate electrode in an electrically floating state, is formed in a thickness of about 400 to about 500 nm, for example, according to the chemical vapor phase deposition method. Instead of the polycrystalline silicon, a silicide of a refractory metal, such as molybdenum silicide or tungsten silicide, may be used.

(6) The polycrystalline silicon layer 6 and the silicon dioxide insulating layer 5 are patterned according to the photolithographic technique.

Fig. 3

(7) A second silicon dioxide insulating layer 7 having a thickness of about 80 to about 100 nm is formed on the exposed surface of the active region of the substrate 1 and on the polycrystalline silicon layer 6, for example, according to the thermal oxidation method.

(8) A polycrystalline silicon layer 8, forming the second gate electrode (i.e., the control electrode), is grown to a thickness of about 400 to about 500 nm according to the chemical vapor phase deposition method.

(9) The second polycrystalline silicon layer 8 and the second insulating layer 7 are patterned according to the photolithographic technique. Thus, the portion of the second silicon dioxide layer 7 formed on the polycrystalline silicon layer 6 in the above-mentioned step (7), which portion has not been covered with the polycrystalline silicon layer 8 in the above-mentioned step (8), is removed whereby a portion of the polycrystalline silicon layer 6 is exposed.

Fig. 4

(10) A third insulating layer 9 of silicon dioxide is grown to a thickness of, for example, about 5 to about 30 nm, for example, according to the thermal oxidation method on the exposed surface of the polycrystalline silicon layer 8, on the exposed surface of the polycrystalline silicon layer 6 and on the exposed surface of the substrate 1.

The third insulating layer 9 of silicon dioxide should have a thickness sufficient for passage of electrons from the first polycrystalline silicon layer 6 (i.e., first gate electrode) to a third polycrystalline silicon layer 10 (i.e., an erasing electrode to be formed on the third insulating layer 9) through the tunneling effect thereby discharging the first gate electrode, when the written information is erased in the resulting memory device. This thickness of the third insulating layer 9 should preferably be maintained at least at a part of the side wall 6' of the first polycrystalline silicon layer 6. Such thickness for the intended passage of electrons by the tunnel effect is usually in the range of from 5 to 30 nm, more preferably from 10 to 20 nm.

(11) A polycrystalline silicon layer 10 for the third gate electrode (i.e., the erasing electrode) is grown to a thickness of about 400 nm according to the chemical vapor phase deposition method.

(12) The polycrystalline silicon layer 10 and the third insulating layer 9 are patterned according to the photolithographic technique.

Fig. 5

(13) Arsenic ions are injected according to the ion inplantation method or other appropriate technique to form an $n^+$ type region 11.

(14) An insulating layer 12 of phosphosilicate glass or silicon dioxide is formed in a thickness of, for example, about 1 micron according to the chemical vapor phase deposition method.

(15) The insulating layer 12 is patterned according to the photolithographic technique to form electrode contact windows 12A.

Fig. 6

(16) An aluminum (A) film having a thickness of, for example, about 1 micron is formed according to the vacuum evaporation deposition method, and the aluminum film is patterned according to the photolithographic technique to form a bit line electrode lead 13.

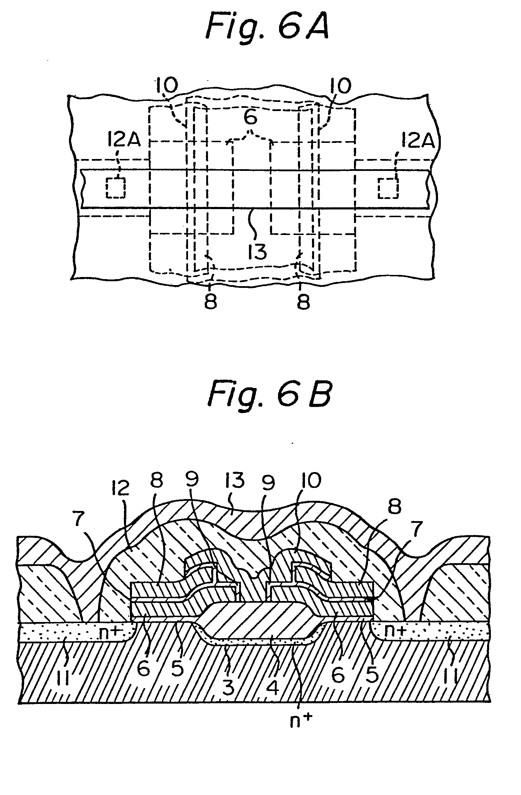

(17) Then, a cover film, electrode windows and the like are formed according to customary techniques. Thus, a semiconductor memory device is obtained wherein, as illustrated in Figs. 6A and 6B, one or more pairs of the first gate electrodes 6 and one or more pairs of the control electrodes 8 are disposed so that the two first gate electrodes 6 in each pair are symmetric to each other, relative to the erasing electrode 10, and the two control electrodes 8 in each pair are also symmetric to each other, relative to the erasing electrode 10.

The device which has been fabricated according to the above procedures is operated as follows.

Writing

The polycrystalline silicon layer 10 for the third gate electrode, which acts as a charge-releasing gate or an erasing electrode, and the n+ type region 3 acting, as a source region, are maintained at the same potential level (ground potential level), and in this state, a positive high voltage is applied to the polycrystalline silicon layer 8 for the second gate electrode which acts as a control gate, whereby electrons are injected into the polycrystalline silicon layer 6 for the first floating gate electrode. The voltage applied is usually in the range of from about 20 to about 30 volts, preferably from about 20 to about 25 volts.

Reading

The polycrystalline silicon layer 10 for the third gate electrode, which acts as a charge-releasing gate, is maintained at the ground potential level, and a voltage of, for example, +5 V is applied to the polycrystalline silicon layer 8 forming the second gate electrode and a voltage of, for example, +1 V is applied to the aluminum lead 13, which acts as a bit line to read the difference of the threshold voltage (Vth) among the respective memory cells.

Erasing

The same high voltage is applied to both the polycrystalline silicon layer 8, forming the second gate electrode which acts as a control gate, and the polycrystalline silicon layer 10, forming the third gate electrode which acts as a charge-releasing gate, or a positive high voltage is applied only to the polycrystalline silicon layer 10 forming the third gate electrode, whereby charges accumulated in the polycrystalline silicon layer 6 for the first gate electrode are released. The voltage applied in this erasing stage may be approximately the same as that applied in the above-mentioned writing stage, that is, usually in the range of from about 20 to about 30 volts, preferably from about 20 to about 25 volts. This release of charges in the polycrystalline silicon layer 6 forming the first gate electrode and passing to the polycrystalline silicon layer 10, forming the third gate electrode, is accomplished by utilising the tunnel effect generated, because the intervening insulating layer 9 is very thin, that is, 5 to 30 nm.

As will be apparent from the foregoing description, according to an embodiment of the present invention, there is provided an EPROM device comprising (i) first gate electrodes in an electrically floating state, at least a part of each of which confronts a channel region of a semiconductor substrate and is separated by a thin insulating layer from the confronted channel region, (ii) second gate electrodes (i.e. control electrodes), at least a part of each of which confronts a respective first gate electrode and is separated therefrom by a thin insulating layer, and (iii) a third gate electrode (i.e. an erasing electrode), at least a part of which confronts the first gate electrodes (and which, preferably, also confronts the second gate electrodes) and is separated therefrom by a very thin insulating layer. In this EPROM device, charges accumulated in the first gate electrodes (i.e., the floating gates) can be released very easily by applying a relatively low voltage (i.e. about 20 to about 30 volts) at least to the erasing electrode. Accordingly, erasing of the formation can be effected with a high reliability.

It will be understood that, although a preferred embodiment of the semiconductor memory device of the present invention is herein described specifically on an n-channel type device, the present invention can similarly be applied to a p-channel type device.

**Claims**

1. A semiconductor memory device which comprises a pair of first gate electrodes (6, 6), each in an electrically floating state and at least a part of each of which confronts a channel region of a semiconductor substrate and is separated by an insulating layer (5, 5) from the channel region confronted; a pair of second gate electrodes (8, 8), that are control electrodes for controlling the injection of charges into the said first gate electrodes, at least a part of each of which confronts a respective first gate electrode and is separated by an insulating layer (7, 7) from the respective first gate electrode; and a third gate electrode (10), insulated from the said second gate electrodes, that is an erasing electrode, at least a part of which confronts the two first gate electrodes and is separated from the first gate electrodes by an insulating layer (9) having a tunnellable thickness, allowing passage of charges from the first gate electrodes to the erasing electrode through the tunnelling effect for discharging the first gate electrodes.

2. A semiconductor memory device according to claim 1, wherein the erasing electrode (10) confronts respective side walls of the two first gate electrodes, which side walls are separated from the erasing electrode by said insulating layer of the tunnellable thickness.

3. A semiconductor memory device according to claim 1 or 2, wherein the said tunnellable thickness is 5 to 30 nm.

4. A semiconductor memory device according to claim 1, 2 or 3, wherein said tunnellable thickness is 10 to 20 nm.

5. A semiconductor memory device according to claim 1, 2, 3 or 4, wherein said insulating layer of the tunnellable thickness is formed by oxidizing surfaces of the first gate electrodes.

6. A semiconductor memory device according to any preceding claim, wherein the two first gate electrodes are disposed symmetrically to one another, relative to the erasing electrode, and the two control electrodes are disposed symmetrically to one another, relative to the erasing electrode.

7. A semiconductor memory device according to claim 6, wherein a field insulating layer (4) divides the insulating layers (5, 5) which separate each first gate electrode from the channel region confronted thereby, at least part of each of the first gate electrodes being formed on the field insulating layer (4), and the part of the erasing electrode (10) which confronts the two first gate electrodes being formed above the field insulating layer (4).

8. A semiconductor memory device according to any preceding claim, wherein parts of the third gate electrode confront parts of the respective second gate electrodes, separated therefrom by insulating material.

**Patentansprüche**

1. Halbleiterspeicher mit einem ersten Paar von Elektroden (6, 6), die jeweils in einem elektrisch schwebenden Zustand sind und von denen wenigstens ein Teil einem Kanalbereich des Halbleitersubstrats konfrontiert und durch eine isolierende Schicht (5, 5) von diesem Kanalbereich getrennt ist, einem Paar von zweiten Gateelektroden (8, 8), die Steuerelektroden sind um die Ladungsinjektionen in die genannten ersten Gateelektroden zu steuern und von denen wenigstens ein Teil jeweils einer entsprechenden ersten Gateelektrode konfrontiert und durch eine isolierende Schicht (7, 7) von der entsprechenden ersten Gateelektrode getrennt ist, und einer dritten Gateelektrode (10), die von den genannten zweiten Gateelektroden isoliert und eine Löschelektrode ist, von der wenigstens ein Teil mit den beiden ersten Gateelektroden konfrontiert und von den ersten Gateelektroden durch eine isolierende Schicht (9) getrennt ist, welche eine durchtunnelbare Dicke aufweist, die den Durchgang von Ladungen von den ersten Gateelektroden zu der Löschelektrode durch den Tunneleffekt zur Entladung der ersten Gateelektroden erlaubt.

2. Halbleiterspeicher nach Anspruch 1, bei welchem die Löschelektrode (10) entsprechenden Seitenwänden der ersten beiden Gateelektroden konfrontiert ist, und die Seitenwände von der Löschelektrode durch die genannte Isolierschicht von durchtunnelbarer Dicke getrennt ist.

3. Halbleiterspeicher nach Anspruch 1 oder 2, bei welchem die durchtunnelbare Dicke 5 bis 30 nm ist.

4. Halbleiterspeicher nach Anspruch 1, 2 oder 3, bei dem die durchtunnelbare Dicke 10 bis 20 nm ist.

5. Halbleiterspeicher nach Anspruch 1, 2, 3 oder 4, bei dem die genannte isolierende Schicht von durchtunnelbarer Dicke durch Oxidieren von Oberflächen der ersten Gateelektroden gebildet ist.

6. Halbleiterspeicher nach einem der vorhergehenden Ansprüche, bei dem die beiden ersten Gateelektroden symmetrisch zueinander relativ zu der Löschelektrode angeordnet sind und die beiden Steuerelektroden symmetrisch zueinander relativ zu der Löschelektrode angeordnet sind.

7. Halbleiterspeicher nach Anspruch 6, bei dem eine Feldisolierschicht (4) die isolierenden Schichten (5, 5) teilt, welche jede erste Gateelektrode von dem konfrontierten Kanalbereich trennen, wodurch wenigstens ein Teil von jeder ersten Gateelektrode auf der Feldisolierschicht (4) geformt ist und der Teil der Löschelektrode (10), der den beiden ersten Gateelektroden konfrontiert ist, oberhalb der Feldisolierschicht gebildet ist.

8. Halbleiterspeicher nach einem der vorhergehenden Ansprüche, bei dem Teile der dritten Gateelektrode Teilen der entsprechenden zweiten Gateelektroden konfrontiert sind, die von diesen durch isolierendes Material getrennt sind.

**Revendications**

1. Mémoire à semiconducteur, caractérisée en ce qu'elle comprend une paire de premières électrodes de grille (6, 6), dont chacune est dans un état électriquement flottant et dont au moins une partie de chacune est située en face d'une région de canal d'un substrat semiconducteur et séparée par une couche isolante (5, 5) de la région de canal située en face d'elle; une paire de deuxièmes électrodes de grille (8, 8), qui sont des électrodes de commande servant à commander l'injection de charges dans les premières électrodes de grille, dont au moins une partie de chacune est située en face d'une première électrode de grille respective et séparée par une couche isolante (7, 7) de la première électrode de grille respective; et une troisième électrode de grille (10), isolée desdites deuxièmes électrodes de grille, qui est une électrode d'effacement, dont au moins une partie est située en face des deux premières électrodes de grille et séparée des premières électrodes de grille par une couche isolante (9) ayant une épaisseur pouvant donner lieu à un effet de tunnel, en permettant le passage de charges des premières électrodes de grille à l'électrode d'effacement par l'effet de tunnel pour décharger les premières électrodes de grille.

2. Mémoire à semiconducteur selon la revendication 1, caractérisée en ce que l'électrode d'effacement (10) est située en face de parois latérales respectives des deux premières électrodes de grille, ces parois latérales étant séparées de l'électrode d'effacement par ladite couche isolante pouvant donner lieu à un effet de tunnel.

3. Mémoire à semiconducteur selon l'une quelconque des revendications 1 et 2, caractérisée en ce que ladite épaisseur pouvant donner lieu à un effet de tunnel est comprise entre 5 et 30 nanomètres.

4. Mémoire à semiconducteur selon l'une quelconque des revendications 1 à 3, caractérisée en ce que ladite épaisseur pouvant donner lieu à un effet de tunnel est comprise entre 10 et 20 nanomètres.

5. Mémoire à semiconducteur selon l'une quelconque des revendications 1 à 4, caractérisée en ce que la couche isolante d'épaisseur pouvant donner lieu à un effet de tunnel est formée en oxydant des surfaces des premières électrodes de grille.

6. Mémoire à semiconducteur selon l'une quelconque des revendications 1 à 5, caractérisée en ce que les deux premières électrodes de grille sont disposées symétriquement entre elles, par rapport à l'électrode d'effacement, et en ce que les deux électrodes de commande sont disposées symétriquement entre elles, par rapport à l'électrode d'effacement.

7. Mémoire à semiconducteur selon la revendication 6, caractérisée en ce qu'une couche isolante de champ (4) divise les couches isolantes (5, 5) qui séparent chaque première électrode de grille de la région de canal située en face d'elle, au moins une partie de chacune des premières électrodes de grille étant formée sur la couche isolante de champ (4), et la partie de l'électrode d'effacement (10) qui est située en face des deux premières électrodes de grille étant formée au-dessus de la couche isolante de champ (4).

8. Mémoire à semiconducteur selon l'une quelconque des revendications 1 à 7, caractérisée en ce que des parties de la troisième électrode de grille sont situées en face de parties des deuxièmes électrodes de grille respectives, en étant séparées de celles-ci par un matériau isolant.

Fig. 1A

Fig. 1B

Fig. 2A

Fig. 2B

*Fig. 3 A*

*Fig. 3 B*

*Fig. 4 A*

*Fig. 4 B*

## Fig. 5A

## Fig. 5B

## Fig. 6A

## Fig. 6 B